# EUROPEAN PATENT APPLICATION

(11) **EP 4 746 034 A1**
(43) Date of publication of application: **20.05.2026**
(21) Application number: 25158119.5
(22) Date of filing: 14.02.2025
(51) Int. Cl.: H01L 21/687, H01L 21/673

(54) **DEVICE AND METHOD FOR HANDLING A STORAGE CONTAINER**

(30) Priority: 13.11.2024 EP 24212819
(71) Applicant: Brooks Automation (Germany) GmbH, 78256 Steißlingen (DE)
(72) Inventor: BAUMEISTER, Cornelia, 78647 Trossingen (DE); BECK, Daniel, 78467 Konstanz (DE)
(74) Representative: Dehns Germany Partnerschaft mbB

(57) **Abstract**

Device (200) for handling a storage container (100) for storing semiconductor wafers or lithography masks, the storage container (100) comprising a plurality of plates (112, 114,116,118) defining a housing (110), the device (200) being configured for engagement with a first one of the plurality of plates, the device (200) being further configured for engagement with at least a further one of the plurality of plates.

## Description

The present invention relates to a device and method for handling a storage container, in particular a storage container for storing semiconductor wafers, from which semiconductor chips are made, and/or lithography masks, which are used for chip manufacture.

### Background

Front opening unified pods (FOUPs) are specialized storage containers designed to hold wafers, in particular semiconductor wafers, in a controlled environment of semiconductor fabrication plants, so called fabs. FOUPs are typically used to transport wafers between method steps to prevent the wafers being contaminated. For this purpose, FOUPs provide a controlled environment in which pressure, airflow and particle-content is controlled. Similar requirements exist for transportation or storage containers for lithography masks (often referred to as reticles), e.g. EUV lithography masks, which are stored and/or transported in dedicated containers, so called reticle pods.

The controlled environment during transportation of wafers and/or lithography masks is essential for the fabrication of highly integrated electric circuits on the wafers with the lithography mask, as even minor contamination can lead to errors in the electronic circuits on the chips, which can result in a whole batch of chips being unusable, thus reducing the yield, which can for example be defined as the percentage of usable chips per reticle.

However, over time, FOUPs can be contaminated by gases from manufacturing processes or by chemical compounds emitted from the wafers and/or lithography masks stored therein. To flush out ("purge") most of the contamination molecules and/or ions, FOUPs are provided with purge openings, through which an inert gas can flushed into the FOUP.

Further, to prevent contamination molecules being transferred from one batch of wafers to another, FOUPs are cleaned regularly, in particular from the inside and the outside.

Furthermore, FOUPs are subjected to various forces, especially torques during their transportation in the fab environment, which leads to wear and tear, such that a FOUP only has a limited lifetime, during which it can be used in a reliable way.

### Summary of the Invention

The present invention addresses these issues by providing a device and method for handling a storage container, in particular a storage container for storing semiconductor wafers and/or lithography masks comprising the features of the respective independent claims.. Further embodiments and additional features are provided in the dependent claims and further discussed in the following description.

The invention provides a device and a method for handling a storage container for storing semiconductor wafers or lithography masks, the storage container comprising a plurality of plates defining a housing, the device being configured for engagement with a first one of the plurality of plates, the device being further configured for engagement with at least a further one of the plurality of plates. By configuring the handling device in this way, strain, for example due to torque effects and/or asymmetrical weight distributions, which the FOUP is subjected to during handling, can be minimised or avoided.

The invention especially provides a device for handling a storage container for storing semiconductor wafers or lithography masks, the storage container comprising a plurality of plates or walls defining a housing, at least one of the plurality of plates being provided with an adaptor, also referred to as handling flange, the device comprising a transportation arm configured for engagement with the adaptor, the device being provided for further engagement with at least a further one of the plurality of plates, especially a plate adjacent to the plate provided with the adaptor. By providing multiple engagements or engagement points in this way, torque forces acting on the handling device as well as on the storage container in various orientations can be minimised, thereby reducing stress effects on the storage container and thus increasing its life span. For example, FOUPs are typically handled in a first orientation in which the transportation arm engages the adaptor from above (i.e. such that the plate of the FOUP, on which the adaptor is provided is the top plate), so that the FOUP essentially hangs from the adaptor. This exposes the FOUP essentially only to relatively small tensile strain, for which FOUPs are typically well adapted. However, in case the FOUP is engaged by the transportation arm in a second orientation such that the plate, on which the adaptor is provided, is on a side of the FOUP, for example, significant torque forces act on the adaptor and on the FOUP as a whole, which lead to an acceleration of degradation of the FOUP.

Such an engagement of the FOUP is especially useful for handling situations, in which a load opening of the FOUP faces downwardly, such that it can be placed on a base with its load opening, the base constituting part of a cleaning system such that the inside of the FOUP can be cleaned using the FOUP itself as its own cleaning chamber. This handling can especially be provided by gripping the adaptor laterally, i.e. from the side. In this case, the plate of the FOUP constituting its lid is removed, and the load opening of the FOUP thus provided is placed face down on the base, via which at least in part upwardly directed cleaning fluid can be directed into the inside of the FOUP by means of appropriately positioned cleaning fluid nozzles. In this orientation, with the load opening facing downwardly, the plate of the FOUP provided with the adaptor is positioned at the side of the FOUP, i.e. in a vertical orientation, and constitutes a side wall.

Be it noted in order to handle a FOUP while its load opening is facing downwardly in the way described above, the FOUP can also be handled or gripped by a handling device from above at a plate opposite the loading opening of the FOUP. In this orientation also, the plate comprising the adaptor is in a lateral position, such that an asymmetrical force can act on the handling device, especially a transportation arm, for example due to the weight of the adaptor. This can also lead to undue strain or torque within the FOUP, leading to an acceleration of degradation.

The device may comprise a clamping structure adapted to provide the further engagement with the at least further one of the plurality of plates, the clamping structure especially being connected to the transportation arm. A clamping structure constitutes a simple and robust arrangement for providing engagement between FOUP and handling device at multiple locations.

The clamping structure may be connected to the transportation arm in such a way that it can engage with the at least further one of the plurality of plates when the transportation arm is in engagement with the adaptor.

The clamping structure can be articulately and/or telescopically connected to the transportation arm, especially to the end of the transportation arm in engagement with the adaptor. Hereby, various engagement positions, which may differ with different types or dimensions of FOUPs, can be effectively selected. Especially, the clamping structure can be provided to contact or engage specific locations on the outside of the FOUP, which constitute acceptable locations for engagement for example according to specific industry standards.

As mentioned, the invention is especially applicable in case the storage container is a FOUP, but is also advantageously useable with other types of storage containers in the semiconductor fab environment

The invention also especially provides a method for handling a storage container for storing semiconductor wafers or lithography masks, the storage container comprising a plurality of plates defining a housing , at least one of the plurality of plates being provided with an adaptor, comprising engagement of the adaptor with a transportation arm of a handling device, the transportation arm being configured for engagement with the adaptor, and further engagement with at least a further one of the plurality of plates, especially a plate adjacent to the plate provided with the adaptor, especially with a clamping structure connected to the transportation arm.

### Brief description of the drawings

Advantages and further aspects of the invention will now be discussed further with reference to the appended drawings. Herein,
Figure 1 shows a perspective view of a prior art FOUP as a storage container, with which the present invention can be implemented,
Figure 2 shows a schematic side view of a FOUP being handled using a device according to an embodiment of the present invention in an orientation, in which the plate provided with the adaptor extends in a vertical direction, i.e. in parallel to the force of gravity, and
Figure 3 shows a schematic side view of a FOUP being handled using a device according to a further embodiment of the present invention similar to that of Figure 2.

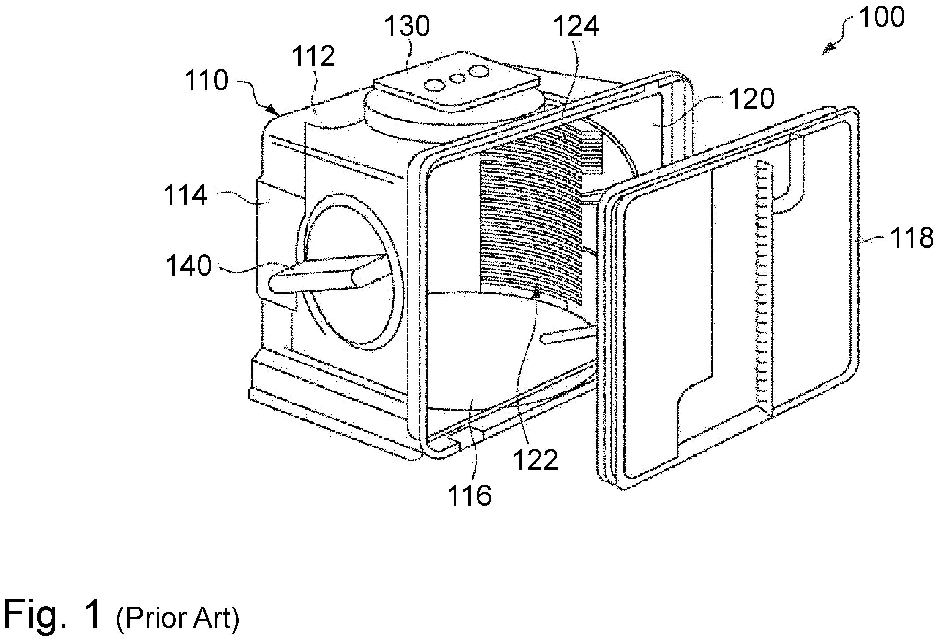

In Figure 1, a perspective view of prior art FOUP is shown as a typical storage container 100, with which the present invention can be implemented. The FOUP 100 comprises a plurality of plates 112, 114 116, 118 forming a box-shaped housing 110 of the FOUP 100. Plate 118 is detachable from the remaining plates 112,114,116 and constitutes a lid of the FOUP, the remaining plates forming the main body of the FOUP and defining a loading opening 124, via which wafers to be stored can be brought into the FOUP.

The FOUP is provided with handling members 140 for manual handling by human operators to hold or transport the FOUP 100. The inside of FOUP 100 is provided with a plurality of ridges 122 adapted to support the peripheral portions of opposite sides of wafers.

Further, a handling flange or adaptor 130 is provided on a top plate 112 of the FOUP 100. The adaptor 130 is used in case of handling by handling devices (handling robots) for handling and transporting the FOUP 100, for example within a fab environment.

The plate 118 and/or the plates engaging plate 118 can be provided with a sealing ring that seals the FOUP 100, when plate 118 is placed in the loading opening 124.

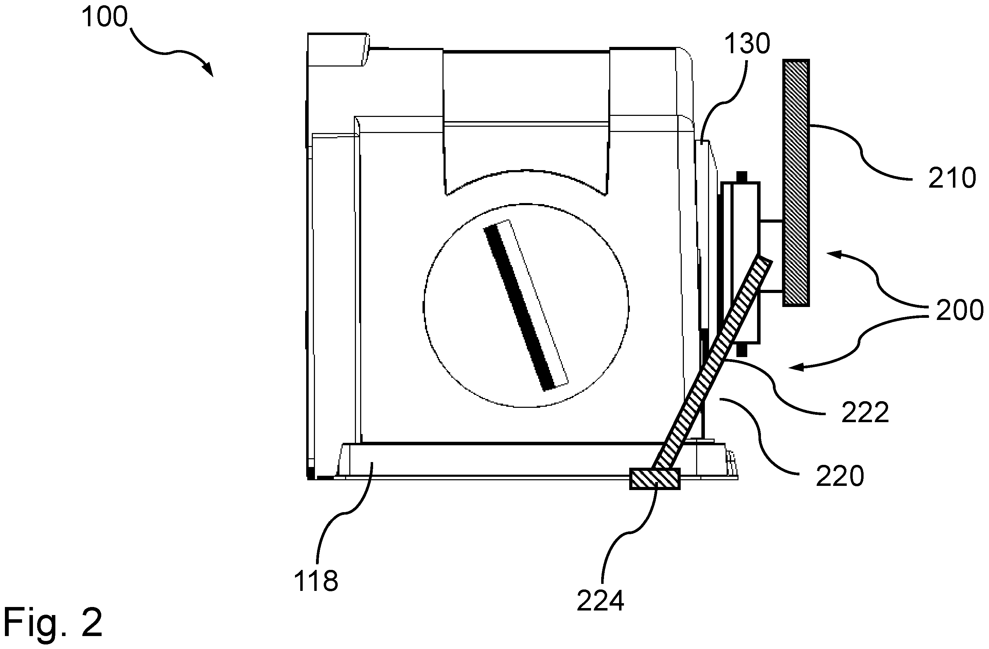

In Figure 2, a FOUP 100 is shown in engagement with an embodiment of the handling device 200 according to the invention. Herein, a transportation arm 210 of the handling device provided with an end for engaging the adaptor is provided. As can be seen in Figure 2, the plate provided with the adaptor 130 is orientated such that it extends in a vertical direction, i.e. parallel to the direction of the force of gravity. In the orientation shown, plate 118 constituting the lid of the FOUP 100 thus extends horizontally, i.e. perpendicularly to the force of gravity. Handling a FOUP 100 in this orientation can be expedient in connection with placing FOUPs in specific kinds of cleaning or handling stations within a fab.

In this orientation, the weight of the FOUP exerts a significant torque force on the adaptor 130, which causes excessive strain within the various plates of the FOUP. Such strain can lead to premature degradation of the FOUP, for example as gas tightness of the loading opening 124 when closed by plate 118 constituting the FOUP lid can deteriorate. Also, material fatigue can occur.

In order to minimise these torque forces and strains, handling device 200 is also provided with a clamping structure 220. An engagement arm 222 of the clamping structure 220 is articulately connected to the end of the transportation arm 210 engaging the adaptor 130 with its first end. At its second end it is provided with an engagement feature 224 adapted to engage with specific positions on the outside of FOUP 100. In the example shown, it engages plate 118 in such a way that at least part of the weight of the FOUP 100 is carried by the engagement arm 222 and/or the engagement feature 224, hereby significantly reducing torque or torque forces acting on the transportation arm 210 and/or the adaptor 130 of the FOUP. Hereby, strain within the FOUP structure can be minimised. The exact positioning of the engagement feature 224 can be varied. For example, the engagement feature 224 could also engage the FOUP 100 at least one of the, in this orientation, vertically extending plates, for example plate 114.

While in Figure 2 the FOUP 100 is shown resting on the engagement feature, i.e. the engagement feature is located below the FOUP, it is also possible to provide the engagement arm and the engagement feature above the FOUP in such a way that the FOUP, or at least a part of the weight of the FOUP, is suspended from the Engagement feature 224, whereby torque and torque induced strain on the FOUP can also be significantly reduced.

Such an engagement by handling the adaptor 130 from the side is for example employed in connection with cleaning methods, in which the FOUP 100 itself is used as a cleaning chamber when cleaning the inside of the FOUP. In this case, the plate 118 of the FOUP 100 constituting its lid is removed, and the loading opening 124 of the FOUP thus provided is placed face down on a base (not shown), via which cleaning fluid can be brought into the inside of the FOUP 100 by means of appropriately positioned cleaning fluid nozzles (also not shown). In this orientation, with the loading opening 124 facing downwards, the plate 112 of the FOUP 100 provided with the adaptor 130 is typically positioned at the side of the FOUP, i.e. in a vertical orientation, and constitutes a side wall of the FOUP.

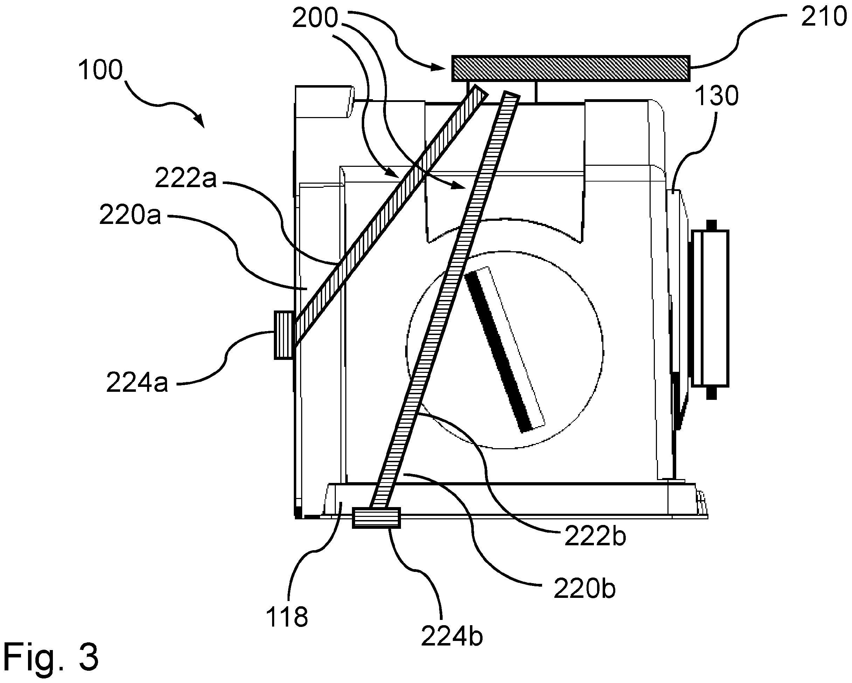

Handling of a FOUP 100 with its load opening 124 facing downwardly can also be achieved by gripping the FOUP at a plate opposite the handling opening 124, i.e. the plate opposite the plate constituting lid 118, as shown in Figure 3.

Here, the FOUP is gripped by a handling device 200 comprising a handling arm 210 from above. In this orientation also, the plate comprising the adaptor 130 is in a lateral position, such that an asymmetrical force can act on the handling device 200, especially the transportation arm 210, for example due to the weight of the adaptor 130. This can also lead to undue strain or torque within the FOUP 100, leading to an acceleration of degradation. In order to minimise or avoid this strain or torque, the handling device according to Figure 3 is also provided with a clamping structure. In order to illustrate various different engagement positions, a first clamping structure designated 220a provided with an engagement arm 222a engaging a (vertically extending) side plate with clamping feature 224a, and a second clamping structure designated 220 b provided with an engagement arm 222b engaging a (horizontally extending) downwardly facing plate with clamping feature 224 b are shown. Clamping structures 220a and 220b may be provided or used individually or simultaneously.

Be it noted that in many fab applications, the plate of the FOUP 100 provided with the adaptor will constitute the top plate of the FOUP, so that the transportation arm will engage the FOUP from above. In this orientation, essentially only downward forces parallel to the force of gravity will act on the transportation arm and/or the adaptor of the FOUP, with essentially no torque being generated, which could act on the adaptor. While in this orientation minimising torque using a clamping structure as described above will not have the same torque reducing effects, it may nevertheless be used to more uniformly distribute the weight of the FOUP that the handling device has to carry.

## Claims

1. Device (200) for handling a storage container (100) for storing semiconductor wafers or lithography masks, the storage container (100) comprising a plurality of plates (112, 114,116,118) defining a housing (110), the device (200) being configured for engagement with a first one of the plurality of plates, the device (200) being further configured for engagement with at least a further one of the plurality of plates.

2. Device (200) for handling a storage container (100) for storing semiconductor wafers or lithography masks according to claim 1, at least one (112) of the plurality of plates being provided with an adaptor (130), the device comprising a transportation arm (210) being configured for engagement with the adaptor (130), the device being provided for further engagement with at least a further one of the plurality of plates, especially a plate (114, 118) adjacent to the plate (112) provided with the adaptor.

3. Device (100) according to claim 1 or 2, further comprising a clamping structure (220) adapted to provide the further engagement with the at least further one of the plurality of plates, the clamping structure (220) especially being connected to the transportation arm (210).

4. Device according to claim 3, wherein the clamping structure (220) is connected to the transportation arm (210) in such a way that it can engage with the at least further one of the plurality of plates (112, 114,116,118) when the transportation arm (210) is in engagement with the adaptor (130).

5. Device (100) according to any one of the preceding claims 2 to 4,
wherein the clamping structure (220) is articulatedly and/or telescopically connected to the transportation arm (210), especially to an end of the transportation arm (210) configured for engagement with the adaptor (130).

6. Device (200) according to any one of the preceding claims, wherein the storage container (100) is a FOUP.

7. Method for handling a storage container (100) for storing semiconductor wafers or lithography masks, the storage container (100) comprising a plurality of plates (112, 114, 116, 118) defining a housing (110), comprising engagement of a first one of the plurality of plates with a handling device (200), and further engagement with at least a further one of the plurality of plates with the handling device, the handling device especially comprising a clamping structure (220) provided with a transportation arm (210) adapted for engagement with the first and the further one of the plurality of plates.

8. Method for handling a storage container (100) for storing semiconductor wafers or lithography masks according to claim 7, at least one (112) of the plurality of plates being provided with an adaptor (130), comprising engagement of the adaptor (130) with the transportation arm (210) of the handling device (200), and further engagement with at least a further one of the plurality of plates, especially a plate (114, 118) adjacent or opposite to the plate (112) provided with the adaptor (130), with the clamping structure.

9. Method according to claim 7 or 8, wherein the storage container (100) is a FOUP.
